# EUROPÄISCHE PATENTSCHRIFT

(11) **EP 0 969 288 B1**
(45) Veröffentlichungstag und Bekanntmachung des Hinweises auf die Patenterteilung: **26.01.2005**
(21) Anmeldenummer: 99110002.5
(22) Anmeldetag: 21.05.1999
(51) Int. Cl.: G01R 31/316, H01L 21/66

(54) **Prüfanordnung für Bondpad**
Test arrangement for bond pad
Dispositif de test pour plage de contact

(30) Priorität: 04.06.1998 DE 19825009
(43) Veröffentlichungstag der Anmeldung: 05.01.2000
(73) Patentinhaber: Infineon Technologies AG, 81669 München (DE)
(72) Erfinder: Schamberger, Florian, 83435 Bad Reichenhall (DE); Schneider, Helmut, 80993 München (DE)
(74) Vertreter: Müller - Hoffmann & Partner

(56) Entgegenhaltungen:
- EP-A- 0 747 930
- US-A- 5 751 015
- PATENT ABSTRACTS OF JAPAN vol. 016, no. 508 (E-1282), 20. Oktober 1992 (1992-10-20) -& JP 04 188643 A (NEC CORP), 7. Juli 1992 (1992-07-07)

## Beschreibung

Die vorliegende Erfindung betrifft eine Prüfanordnung für ein Bondpad zum Feststellen, ob ein Halbleiterchip gebondet ist oder nicht, mit einer den Bondzustand zwischen einem einzigen Bonddraht und dem Bondpad auswertenden Schaltung, die abhängig vom festgestellten Bondzustand Betriebs- und Testmodi zu aktivieren und zu deaktivieren vermag.

Bei der Herstellung von Halbleiterchips und für deren Durchlauf durch Betriebs- und Testmodi sollte immmer bekannt sein, ob die jeweiligen Halbleiterchips bereits zuverlässig gebondet sind oder nicht. Es wäre dabei von besonderem Vorteil, wenn der Halbleiterchip selbst erkennen könnte, ob er bereits gebondet ist oder nicht, damit dann abhängig von seinem jeweiligen Montagezustand die einzelnen Betriebs- und Testmodi aktiviert und deaktiviert werden könnten. Eine derartige Eigenschaft des Halbleiterchips hätte den erheblichen Vorteil, dass dessen Einlegen in ein entsprechendes Prüffeld mit dem damit verbundenen erheblichen Zeitverlust vermieden werden könnte.

Im Einzelnen ist aus der EP-A-0 747 930 eine Schaltungsanordnung mit zwei Bonddrähten bekannt, bei der diese zwei Drähte jeweils einen Teil eines Pads kontaktieren, um so den Bondzustand überprüfen zu können. Weiterhin zeigt auch JP 04 188643 A eine Schaltungsanordnung, in welcher ein Pad in zwei Teilen vorgesehen ist, wobei ein erster Teil mit einer Eingangsverdrahtung und ein zweiter Teil mit Drain eines Transistors verbunden sind. Auch hier liegen also zwei getrennte Drähte vor, so dass jeder Teil des Pads mit einem gesonderte Draht vesehen ist.

Bisher wurde aber nicht daran gedacht, eine Prüfanordnung zu schaffen, mit der ein Halbleiterchip selbst erkennen kann, ob er bereits mit einem einzigen Draht gebondet ist oder nicht.

Der vorliegenden Erfindung liegt daher die vollkommen neue Aufgabe zugrunde, eine Prüfanordnung für Bondpads zu schäffen, mit der ein Halbleiterchip festzustellen vermag, ob er an einem Bondpad bereits mit einem einzigen Bonddraht gebondet ist oder nicht, damit abhängig von seinem so festgestellten Bondzustand jeweilige Betriebs- und Testmodi aktiviert und deaktiviert werden können.

Diese Aufgabe wird bei einer Prüfanordnung der eingangs genannten Art erfindungsgemäß dadurch gelöst, daß der Bondpad in wenigstens zwei Teile geteilt ist, so daß die im Halbleiterchip selbst realisierte Schaltung aus von den Teilen des Bondpads abgeleiteten Signalen festzustellen vermag, ob der Bonddraht die Teile kontaktiert oder nicht.

Vorzugsweise ist der Bondpad in zwei Teile unterteilt. Gegebenenfalls kann aber auch eine Unterteilung in mehr Teile als zwei Teile vorgenommen werden.

Die vorliegende Erfindung beschreibt so einen vom bisherigen Stand der Technik vollkommen abweichenden Weg: Die erfindungsgemäße Prüfanordnung stellt das korrekte Bonden von Bondpads nicht fest, indem extern dem Halbleiterchip über die mit den Bondpads verbundenen Drähte Testsignale zugeführt werden. Vielmehr testet der Halbleiterchip selbst, ob er bereits richtig gebondet ist oder nicht, indem er eine Schaltung enthält, die auswertet, ob die Bondpads, die jeweils in wenigstens zwei Teile geteilt sind, mit einem Bonddraht kontaktiert sind oder nicht.

Dabei wird die Tatsache ausgenutzt, daß der Widerstand zwischen zwei Teilen eines Bondpads, die nicht mit einem Bonddraht verbunden sind, praktisch unendlich groß ist, während der Widerstand zwischen zwei Teilen eines Bondpads, die miteinander elektrisch durch den Bonddraht verbunden sind, gegen Null geht. Die im Halbleiterchip vorgesehene Schaltung wertet also lediglich aus, ob der Widerstand zwischen den beiden Teilen gegen Null oder gegen Unendlich geht.

Derartige Schaltungen können in vielfältiger Weise ausgeführt werden. Sie müssen lediglich in der Lage sein, zu erkennen, ob die wenigstens zwei Teile eines Bondpads durch einen Bonddraht in leitender Verbindung zueinander stehen oder nicht.

Nachfolgend wird die Erfindung anhand der Zeichnungen näher erläutert. Es zeigen:
- Fig. 1: eine Draufsicht auf einen Bondpad, bei dem ein Bonddraht nur einen Teil kontaktiert,
- Fig. 2: eine Draufsicht auf einen bestehenden Bondpad und
- Fig. 3: eine mögliche Schaltung, die zu erkennen vermag, ob die beiden Teile eines Bondpads leitend verbunden sind oder nicht.

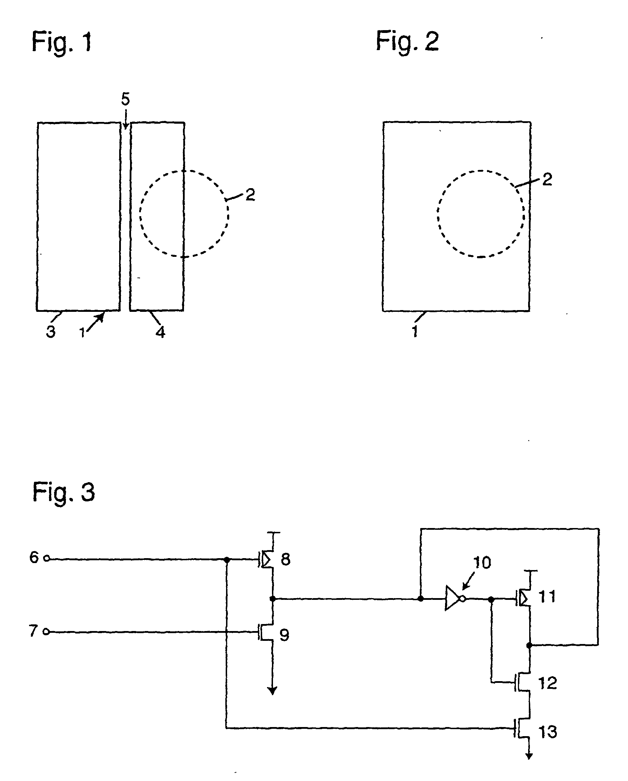

Fig. 2 zeigt einen üblichen Bondpad 1, auf dem, wie in Strichlinien angedeutet ist, ein Bonddraht 2 angebracht ist. Bei dem Beispiel von Fig. 2 kontaktiert der Bonddraht 2 in voller Ausdehnung den Bondpad 1. Es ist nun denkbar, daß der Bonddraht 2 nur teilweise den Bondpad 1 kontaktiert, so daß eine schlechte Verbindung zwischen Bonddraht 2 und Bondpad 1 besteht. Dies kann sogar so weit gehen, daß der Bonddraht 2 neben dem Bondpad 1 den Halbleiterchip berührt, so daß der Bondpad 1 überhaupt nicht kontaktiert ist.

Bei der erfindungsgemäßen Prüfanordnung ist daher der Bondpad 1 in zwei Teile 3, 4 unterteilt, die voneinander durch einen Spalt 5 getrennt sind, wie dies in Fig. 1 gezeigt ist. Das heißt, bei der Anordnung von Fig. 1 geht der elektrische Widerstand zwischen den Teilen 3 und 4, sofern diese nicht in leitender Verbindung durch einen Bonddraht miteinander stehen, gegen Unendlich. Sind diese Teile 3, 4 jedoch durch einen Bonddraht 2 verbunden, so geht der Widerstand zwischen den Teilen 3, 4 gegen Null.

In Fig. 1 ist nun schematisch ein Fall gezeigt, in welchem der Bonddraht 2 nur teilweise den Bondpad 1 kontaktiert, so daß nur der Teil 4 mit dem Bonddraht 2 in elektrischer Verbindung steht. In diesem Fall liegt also eine "schlechte" Kontaktierung des Bondpads 1 durch den Bonddraht 2 vor.

Diese "schlechte" Kontaktierung des Bondpads 1 durch den Bonddraht 2 wird durch die erfindungsgemäße Prüfanordnung ohne weiteres erkannt: Die Teile 3 und 4 stehen nicht in elektrischer Verbindung miteinander, so daß der elektrische Widerstand zwischen den Teilen 3 und 4 gegen Unendlich geht. Dieser Zustand kann ohne weiteres durch eine in dem Halbleiterchip vorgesehene Schaltung festgestellt werden, so daß der Halbleiterchip selbst zu ermitteln vermag, ob er bereits richtig gebondet ist oder nicht.

Liegt der Bonddraht 2 neben dem Bondpad 1 oder ist noch kein Bonden erfolgt, so geht der Widerstand zwischen den Teilen 3 und 4 selbstverständlich auch gegen Unendlich. Auch in diesem Fall kann die Prüfanordnung sofort feststellen, daß der Bondpad noch nicht mit dem Bonddraht kontaktiert ist.

Fig. 3 zeigt als Beispiel eine mögliche Schaltung zur Auswertung des Zustandes der Teile 3, 4 des Bondpads 1. Hierzu sind Anschlüsse 6, 7 dieser Schaltung mit den Teilen 3, 4 verbunden, die, wie in Fig. 1 gezeigt ist, nicht gleich groß zu sein brauchen. Der Anschluß 6 ist mit Gate eines p-Kanal-MOS-Transistors 8 und Gate eines n-Kanal-MOS-Transistors 13 verbunden. Der Anschluß 7 liegt an Gate eines n-Kanal-MOS-Transistors 9. Die Transistoren 8, 9 liegen in Reihe zwischen einer Versorgungsspannung und Masse, wobei ihr gemeinsamer Knotenpunkt an den Eingang eines Inverters 10 und an den gemeinsamen Knotenpunkt eines p-Kanal-MOS-Transistors 11 und eines n-Kanal-MOS-Transistors 12 angeschlossen ist. Der Ausgang des Inverters 10 liegt an Gate des Transistors 11 und an Gate des Transistors 12. Außerdem liegen die Transistoren 11, 12 und 13 in Reihe zwischen Masse und der Versorgungsspannung.

Der Inverter 10 und der Transistor 11 bilden ein Latchglied, in welchem abhängig davon, ob die Anschlüsse 6 und 7 miteinander verbunden sind oder nicht, ein unterschiedlicher Wert gespeichert wird.

Selbstverständlich sind noch andere Ausführungsbeispiele einer Schaltung für die Auswertung des Verbindungszustandes der Teile 3, 4 des Bondpads 1 möglich. Fig. 3 stellt hierfür lediglich ein Beispiel dar.

Der Halbleiterchip kann also sofort erkennen, daß er gebondet ist. Damit können Betriebs- und Testmodi abhängig vom Montagezustand aktiviert oder deaktiviert werden, was einen erheblichen Zeitvorteil bedeutet, da der Halbleiterchip nicht in ein Prüffeld eingebracht zu werden braucht.

## Patentansprüche

1. Prüfanordnung für Bondpad (1) zum Feststellen, ob ein Halbleiterchip gebondet ist oder nicht, mit einer den Bondzustand zwischen einem einzigen Bonddraht (2) und dem Bondpad (1) auswertenden Schaltung, die abhängig vom festgestellten Bondzustand Betriebs- und Testmodi zu aktivieren und zu deaktivvieren vermag,
**dadurch gekennzeichnet,**
**dass** der Bondpad (1) in wenigstens zwei Teile (3, 4) geteilt ist, so dass die im Halbleiterchip selbst realisierte Schaltung aus von den Teilen (3, 4) des Bondpads (1) abgeleiteten Signalen festzustellen vermag, ob der einzige Bonddraht (2) die Teile (3, 4) kontaktiert oder nicht.

2. Prüfanordnung nach Anspruch 1,
**dadurch gekennzeichnet,**
**dass** der Bondpad (1) in zwei Teile (3, 4) geteilt ist.

## Claims

1. Bonding pad test arrangement (1) for establishing whether or not a semiconductor chip is bonded, having a circuit which evaluates the state of the bond between a single bonding wire (2) and the bonding pad (1) and is able to activate and deactivate operating and test modes depending on the bond state established, **characterized in that** the bonding pad (1) is divided into at least two parts (3, 4), so that the circuit produced in the semiconductor chip itself can use signals derived from the parts (3, 4) of the bonding pad (1) to establish whether or not the single bonding wire (2) is in contact with the parts (3, 4).

2. Test arrangement according to Claim 1, **characterized in that** the bonding pad (1) is divided into two parts (3, 4).

## Revendications

1. Dispositif de contrôle de plage (1) de contact pour constater si une puce à semi-conducteur est reliée ou ne l'est pas, comprenant un circuit qui exploite l'état de la liaison entre un fil (2) de liaison unique et la plage (1) de contact et qui peut activer et désactiver des modes de fonctionnement et des modes de test en fonction de l'état de la liaison constaté,
**caractérisé**
**en ce que** l'on subdivise la plage (1) de contact en au moins deux parties (3, 4) de façon à ce que le circuit réalisé dans la puce à semi-conducteur elle-même puisse constater, à partir des signaux dérivés des parties (3, 4) de la plage (1) de contact, si le fil (2) unique de liaison est en contact avec les parties (3, 4) ou ne l'est pas.

2. Dispositif de contrôle suivant la revendication 1,
**caractérisé**
**en ce que** l'on subdivise la plage (1) de contact en deux parties (3, 4).
